# EUROPEAN PATENT SPECIFICATION

(11) **EP 1 090 462 B1**
(45) Date of publication and mention of the grant of the patent: **03.08.2005**
(21) Application number: 99925959.1
(22) Date of filing: 27.05.1999
(51) Int. Cl.: H03M 13/00

(54) **CIRCUIT AND METHOD FOR RAPID CHECKING OF ERROR CORRECTION CODES USING CYCLIC REDUNDANCY CHECK**
SCHALTUNG UND VERFAHREN ZUM SCHNELLEN PRÜFEN VON FEHLERKORREKTURKODEN MIT HILFE EINER ZYKLISCHEN REDUNDANZPRÜFUNG
CIRCUIT ET PROCEDE DE VERIFICATION RAPIDE DES CODES DE CORRECTION D'ERREUR PAR CONTROLE DE REDONDANCE CYCLIQUE

(30) Priority: 27.05.1998 US 85765
(43) Date of publication of application: 11.04.2001
(73) Proprietor: Qlogic Corporation, Costa Mesa, CA 92626 (US)
(72) Inventor: SZE, Hung, Y., La Habra, CA 90631 (US)
(74) Representative: DeVile, Jonathan Mark, Dr.
(86) International application number: PCT/US1999/011819
(87) International publication number: WO 1999/062182

(56) References cited:
- US-A- 5 491 701
- US-A- 5 563 896
- US-A- 5 600 662
- US-A- 5 691 994
- FILIPG: "A Painless Guide to CRC Error Detection Algorithms Index V3.00" HTTP://WWW.REPAIRFAQ.ORG/FILIPG/LINK/F_CRC _V3.HTML, 24 September 1996 (1996-09-24), pages 1-33, XP002171899

## Description

### Field of the Invention

The present invention relates generally to computers. Specifically, the present invention relates to a circuit and method for improving the accuracy and speed of error detection and correction in disk drives.

### Background of the Invention

A conventional disk drive stores data bytes on disk drive platters in sets of a predetermined length. A disk drive controller or the host computer may generate error correction code (ECC) bytes and cyclic redundancy check (CRC) bytes for each set of data bytes. Sometimes, the host computer generates CRC bytes, and the disk controller generates its own set of CRC bytes. The CRC and the ECC bytes are appended to the end of the set of data bytes. The data bytes, CRC bytes and ECC bytes together make up a 'sector,' and this sector is stored on the disk platter. When the disk drive controller reads a sector off the disk, the data bytes and CRC bytes are stored in a buffer unit in the disk drive. An ECC unit detects and corrects errors in the sector read off the platter. These corrections are made to the data bytes and CRC bytes stored in the buffer unit.

The ECC unit may, however, detect no error by mistake when there is actually is an error in the data detected by the CRC unit and CRC bytes read off the disk. If the ECC unit misses an error, it will also not correct the data and CRC bytes to their original values. Another miscorrection situation is where the ECC unit detects a true error but fails to correct the erroneous byte(s) properly. Both of these situations are miscorrections. Disk drives with ECC units that have higher error detection and correction capabilities experience a higher probability of miscorrection.

After the ECC unit makes corrections (or miscorrections) to the data and CRC bytes stored in the buffer unit, the disk drive controller reads the contents of the buffer and transfers these contents across a bus to a host computer. For example, the bus may be a Small Computer Systems Interface (SCSI) bus. As the data is being transferred, a CRC check unit accumulates the 'corrected' data bytes as they are being transferred to the host, generates a CRC residue, and checks for any miscorrections by the ECC. But the CRC check unit does not complete its analysis on whether the transferred data contains any miscorrections until after the data transfer to the host computer is complete. After an incorrect data transfer to the host is complete, the CRC check unit sends a message to the host computer that the data the host computer received contains miscorrections. The host computer must discard the erroneous data bytes and send a request to the disk drive to reread the data bytes from the disk platter and retransmit the data bytes.

This is inefficient because during the time that the host computer receives the erroneous data, receives a message from the CRC check unit, requests the disk drive controller to retransmit the data, and waits for new data to be read and transferred, the host computer could be doing some other task. This is also inefficient because the transmissions, retransmissions and CRC check messages take up bandwidth on the SCSI bus.

Furthermore, there is an detrimental impact on performance on the host side. Some host computers, interfaces and/or software applications cannot process the incorrect data. This results in breakdowns in applications currently being run by the host computer. Some host computers can process incorrect data but they cannot recover quickly, and this causes undesirable delays.

US-A-5600662 discloses an error correction system for correcting bursts of errors in data recovered from a rotating magnetic storage medium. The error correction system comprises a plurality of subsystems which include a multi-purpose CRC generation and checking subsystem and a ECC/syndrome generation subsystem. During a read operation the CRC checking subsystem regenerates a CRC value from a sector of data and compares the CRC value with a value which was generated when the sector was written to the medium.

The ECC subsystem performs error correction decoding on a sector of bytes based on an error syndrome calculated from the error correction code polynominal and by a code word of symbols recovered from the data sector. The syndrome is used to determine coefficients of an error locator polynominal from which an error evaluator polynominal is formed. Furthermore, the CRC checking subsystem is used to verify the correction implemented by the ECC correction subsystem. This is because, the ECC subsystem is applied to the recovered data before the CRC subsystem is applied. The CRC subsystem determines whether the error patterns are identified as being zero, and if not, the error pattern is determined to be uncorrectable by the ECC subsystem.

### Summary of the Invention

Various aspects and features of the present invention are defined in the appended claims.

The present invention provides a circuit and method for improving the accuracy and speed of error detection and correction when reading data from a disk in a disk drive. The present invention uses a CRC unit to monitor both the sector bytes read from the disk platter and the error corrections made by the ECC unit to the data and CRC bytes. The CRC unit uses this information to determine whether the ECC-corrected data bytes stored in the buffer unit is correct.

In contrast to the conventional approach, the CRC unit in the present invention reads data bytes and CRC bytes from the disk simultaneously with the ECC unit. Thus, the CRC unit begins generating a residue to detect errors in the data at approximately the same time the ECC unit begins generating a residue to detect errors in the sector. This saves time because the CRC unit in the present invention does not wait for the ECC unit to finish and transfer the ECC error corrections into a buffer. This eliminates the time spent by a CRC unit reading the contents of the buffer after an ECC unit has finished its attempted corrections.

Another advantage of the present invention is that the circuit and method completes a CRC error check before any data is transferred to the host computer. In other words, the CRC unit must approve the data before the disk drive controller sends the data to the host.

There are at least five situations where the disk drive controller should abort the current read operation and attempt another read operation of the same sector. In one situation, the ECC unit detects an uncorrectable error in the data read from the disk. In another situation, the ECC unit 'detects' one or more correctable errors, and the CRC unit does not detect any errors. This is a misdetection. If the ECC unit tries to correct this data, then a miscorrection occurs. In another situation, the ECC unit does not detect any errors, and the CRC unit does detect errors. In another situation, both the ECC unit and the CRC unit detect the same error(s), but the ECC unit fails to correct the error properly. In another situation, both the CRC unit and the ECC unit detect at least one error, but the detected errors are not the same. In all of these situations, the CRC unit of the present invention informs the disk drive controller. The disk drive controller aborts the read operation, discards the entire read sector, and stops the erroneous data from being transmitted to the host. The disk drive controller attempts another read operation of the same data sector off the disk.

Thus, the CRC unit and disk drive controller of the present invention reduces the amount of erroneous data sent to the host computer. This reduces the problem of the host trying to process the miscorrected data, which could result in breakdowns, software application errors and undesirable delays.

The present invention also avoids the time spent by the host to discard the erroneous data, request a retransmission from the disk drive, and wait for new data to be read and transferred by the disk drive. The host computer saves time and can perform other tasks during this saved time.

The present invention also reduces the bandwidth taken up by the transmissions, retransmissions and CRC check messages on the SCSI bus.

One embodiment of the present invention includes a system for checking one or more corrections made by an error correction code (ECC) unit to a sector of bytes read from a disk in a disk drive. This system comprises at least one disk from which one or more sectors of bytes are read, an ECC unit, a CRC unit, a buffer unit and a disk drive controller. The ECC unit detects and corrects perceived errors in the sector of bytes. The CRC unit checks the corrections made by the error correction unit before the data in the sector is transmitted to a host computer. The CRC unit receives the sector of bytes at the same time the ECC unit receives the sector of bytes. The buffer unit temporarily stores at least a portion of the sector of bytes read from the disk, and implements the corrections by the ECC unit to the sector of bytes. The disk drive controller controls the transmission of the sector of bytes from the buffer unit to the host computer. The disk drive controller aborts the current sector of bytes within the buffer unit and attempts another read operation if the errors found by the CRC unit do not match the errors found by the ECC unit.

Embodiments of the present invention can also provide a method of checking one or more corrections made by an ECC unit to a sector of bytes read from a disk in a disk drive. This method involves reading the sector of bytes into a CRC unit and an ECC unit, generating a CRC residue from data bytes within the sector, and generating an ECC residue from the sector. The CRC unit compares the error locations and error values found by the CRC unit with the error locations and error values found by the ECC unit. The method further involves discarding the current sector read by the disk drive, without sending it to a host computer, and attempting another read operation of the same sector if the error locations or error values detected by the CRC unit do not match the error locations or error values detected by the ECC unit.

### Brief Description of the Drawings

Figure 1 illustrates a sector of bytes in accordance with a preferred embodiment of the present invention.
Figure 2 is a block diagram of a host computer in communication with a disk drive in accordance with a preferred embodiment of the present invention.
Figure 3 is a block diagram of various internal units of the disk drive depicted in Fig. 2.
Figure 4 is a flow chart of the acts performed by a CRC reconciliation module contained within the disk drive depicted in Fig. 2.
Figure 5 illustrates the contents of an error location and value memory module within the disk drive depicted in Fig. 2.
Figure 6 illustrates the events which cause the disk drive depicted in Fig. 2 to abort a read data operation.

### Detailed Description of the Preferred Embodiments

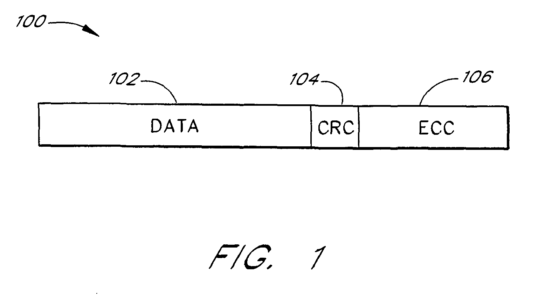

The present invention relates to a circuit and method for performing a CRC check before a disk drive controller reads the contents of a buffer unit and transfers them to a host computer. Figure 1 illustrates a sector 100 of bytes in accordance with a preferred embodiment of the present invention. Each byte contains eight bits. In a preferred embodiment, the data portion 102 of the sector contains 516 bytes, which comprises four bytes of logical block address (LBA) and 512 data bytes. The CRC portion 104 contains two to four bytes and is generated from the data portion 102 using conventional methods. The ECC portion 106 contains 24 to 40 bytes and is generated from the data portion 102 and the CRC portion 104 using conventional methods. The circuit and method are configurable to sectors of various sizes. The specific byte lengths of the data portion 102, CRC portion 104 and ECC portion 106 do not affect the functionality of the present circuit and method. The circuit and method may be adapted to use sectors of different data, CRC and ECC byte lengths.

In a preferred embodiment, the ECC bytes are generated from a four-way interleave of the data 102 and CRC bytes 104. The purpose of interleaving is to correct for burst errors. In a four-way interleave, the data and CRC bytes are counted off in groups of four. In a preferred embodiment, the bytes are counted off from right (i.e. the end) of the sector to the left (i.e. the beginning) of the sector. The first byte at the right of the sector 100 and every fourth byte thereafter (i.e. the first byte, the fifth byte, the ninth byte, etc. from right to left) are grouped together to form a first interleave, which is used by the disk drive controller to generate a first ECC block. The second byte from the right (end) of the sector 100 and every fourth byte thereafter (i.e. the second byte, the sixth byte, the tenth byte, etc.) are grouped together to form a second interleave, which is used to generate a second ECC block. The third byte from the right (end) of the sector 100 and every fourth byte thereafter (i.e. the third byte, the seventh byte, the eleventh byte, etc.) of the sector 100 are grouped together to form a third interleave, which is used to generate a third ECC block. The fourth byte from the right (end) of the sector 100 and every fourth byte thereafter (i.e. fourth byte, eighth byte, twelfth byte, etc.) of the sector 100 are grouped together to form a fourth interleave, which is used to generate a fourth ECC block. The count-off does not necessarily have to start from the right to the left in the sector 100. In other embodiments, the interleave sequence may start from the left or in any other ordered sequence.

From these four interleaves, the disk drive controller 126 generates four corresponding ECC blocks. In one embodiment with 40 ECC bytes, each ECC block is 10 bytes long. Each ECC block is used to detect and correct the errors in the interleave associated with that particular ECC block. In another embodiment, the disk drive 110 uses three interleaves. An ECC generated from three or four interleaves can correct up to 20 bytes.

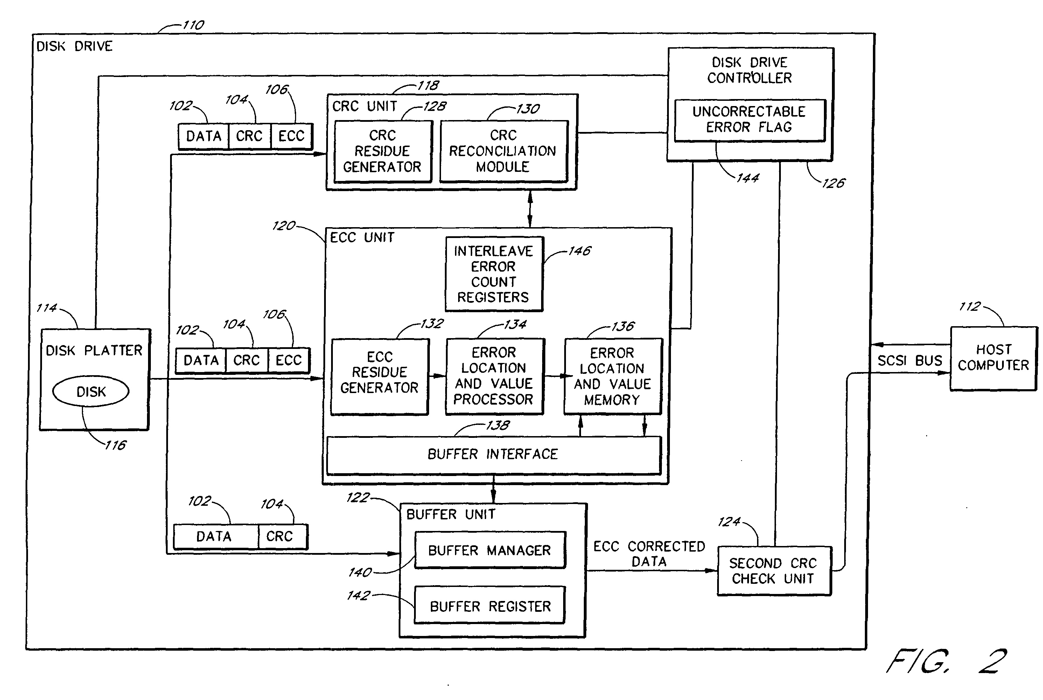

Figure 2 is a block diagram of a host computer 112 in communication with a disk drive 110 in accordance with a preferred embodiment of the present invention. The disk drive 110 communicates with the host 112 across a bus. In one embodiment, the bus is a Small Computer Systems Interface (SCSI) bus. The disk drive 110 comprises at least one disk platter 114, a CRC unit 118, an ECC unit 120, a buffer unit 122, a disk drive controller 126, and a second CRC check unit 124. The CRC unit 118, ECC unit 120 and second CRC check unit 124 are preferably independent circuits. The CRC unit 118 comprises a CRC residue generator 128 and a CRC reconciliation module 130. As used here, 'residue' is synonymous with 'syndrome.' In a preferred embodiment, the CRC unit 118 is implemented using a state machine and one or more shift registers. The ECC unit 120 comprises an ECC residue generator 132, a plurality of interleave error count registers 146, an error location and value processor 134, an error location and value memory 136 and a buffer interface 138. The buffer unit 122 comprises a buffer manager 140 and a buffer register 142. The disk drive controller 126 includes at least one uncorrectable error flag 144.

The use and operation of the disk drive 110 will now be described with reference to Figure 2. The disk drive controller 126 initiates a read operation, and the data 102, CRC 104, and ECC 106 portions of a sector 100 are independently read into both the CRC unit 118 and the ECC unit 120. The data portion 102 and the CRC portion 104 of the sector 100 are also read into the buffer unit 122. The order of reading the bytes of a sector 100 begins with the data bytes 102, then the CRC bytes 104 and finally the ECC bytes 106. In Figure 2, the leftmost byte of the data portion 102 is read first.

After the data 102, CRC 104 and ECC 106 bytes are read into the ECC unit 120, the ECC residue generator 132 uses the data 102, CRC 104 and ECC 106 bytes to generate four ECC residues, one for each interleave. In another embodiment, three interleaves are used and the ECC residue generator 132 generates three ECC residues. The total number of bytes of the generated ECC residues is the same as the original ECC portion 106 stored in the sector 100. For example, if the ECC portion 106 is 40 bytes long, the total number of ECC residue bytes is also 40 bytes long. If an ECC residue contains all zeroes, then there are no errors detected by the ECC unit 120 in the interleave associated with that particular ECC block.

If the ECC residues do not contain all zeroes, the ECC unit 120 informs the buffer unit 122 of what the errors are and where the errors are located. Specifically, the error location and value processor 134 uses the ECC residues to determine the location and 'mask' value of any found errors. The error location is one byte long and represents an offset from the end of a sector 100. The mask value is one byte in length and is used to correct an erroneous data or CRC byte. The error location and value processor 134 processes the errors one interleave at a time because each ECC block is associated with one interleave. The error location and value processor 134 finishes processing the errors in one interleave before starting to process the errors for another interleave.

The error location and value processor 134 outputs a list of error locations and mask values for each interleave, one interleave at a time, to the error location and value memory 136. The error location and value memory 136 stores this information. In a preferred embodiment, this error location and value memory 136 is a dual-port memory with an input, two address lines and two data lines. The dual ports allow the buffer interface 138 and the CRC reconciliation module 130 to read the error location and value memory 136 independently at their own respective speeds. Thus, both the buffer interface 138 and the CRC reconciliation module 130 may be reading from the memory 136 at the same time without interference.

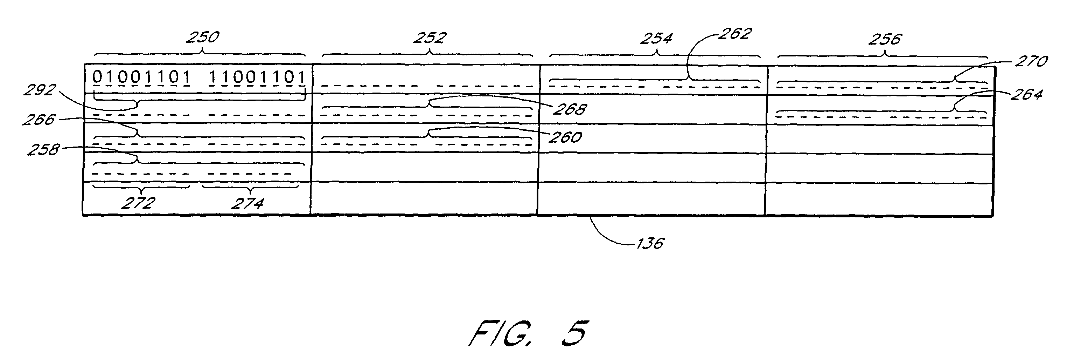

Figure 5 illustrates the contents of the error location and value memory 136. The error location and value memory 136 contains four error entry blocks 250, 252, 254, 256, one block for each of the four interleaves. For example, the first block 250 corresponds to all errors found in the first interleave. In the preferred embodiment, the last error entry on the bottom of each of the four blocks 250, 252, 254, 256 represents the earliest erroneous byte found in that interleave. For example, the location and error value of the first erroneous byte found by the ECC unit 120 in the first interleave is initially stored in the first error entry space 292 of the first interleave error block 250. If the ECC unit 120 finds three more erroneous bytes in the first interleave, the first erroneous byte entry is pushed down until it reaches the fourth error entry space 258. This 'push down' principle applies to all four interleave error entry blocks 250, 252, 254, 256.

Each error entry in a block 250, 252, 254, 256 is two bytes long -- the first byte contains the error location and the second byte contains the mask value. For example, in the last error entry 258 of the first interleave error entry block 250, the first eight bits 272 represent an error location and the second eight bits 274 represent a mask value used to correct the erroneous byte.

In the preferred embodiment, the size of the error location and value memory 136 is preferably 40 bytes because a 40-byte ECC generated from four interleaves can correct up to 20 bytes of data (and CRC) in a 512-byte data block. Because each erroneous byte is represented by two bytes (one for location and one for the mask value), 40 bytes are required. Thus, the maximum size of the error location and value memory 136 needed for a 40-byte ECC with four interleaves is 40 bytes. This is shown by Figure 5. Any extra memory space will not be used and is inefficient. In another embodiment, where an ECC shorter than 40 bytes is used, the memory size may be fewer than 40 bytes because a shorter ECC detects less erroneous bytes.

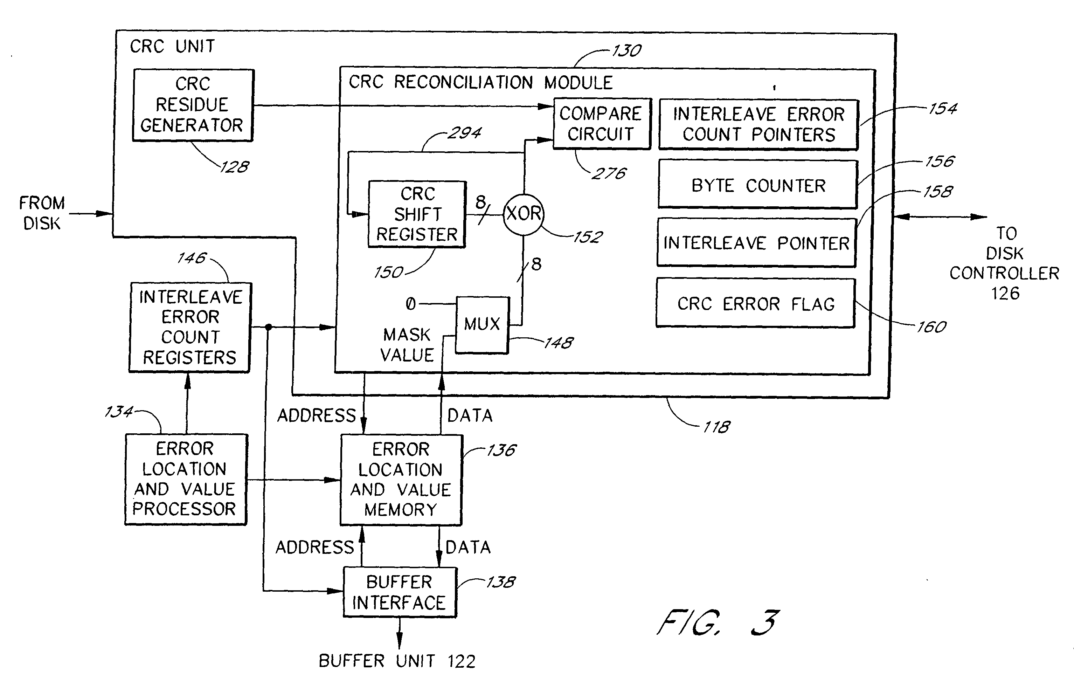

In Figures 2 and 3, a set of interleave error count registers 146 in the ECC unit 120 keeps track of how many error entries are stored in the error location and value memory 136 for each interleave. In a preferred embodiment, there are four interleaves and thus four corresponding interleave error count registers 146. For example, the first interleave error count register stores the number of erroneous bytes in the first interleave. The interleave error count registers 146 are read by both the buffer interface 138 and the CRC reconciliation module 130, as shown by Figure 3. In another embodiment, the interleave error count registers 146 may be within the CRC unit 118 instead of the ECC unit 120.

Similar to the error location and value processor 134, the buffer interface 138 processes the errors one interleave at a time because each ECC block is associated with one interleave. The buffer interface 138 finishes processing the errors in one interleave before starting to process the errors for another interleave. The buffer interface 138 reads the error location and value memory 136 and translates the error locations to actual memory locations. The buffer manager 140 uses the memory locations to correct the erroneous byte(s).

To correct the erroneous byte, the buffer manager 140 performs an exclusive-OR operation between the erroneous byte and the mask value associated with that erroneous byte. For example, if an original data byte stored on the disk platter 114 is 00000000, and the disk drive 110 reads the data byte as 00010000, then there is an error in the fourth bit from the left. The corresponding mask value for this particular byte would be 00010000. To correct this byte, the buffer interface 138 in the ECC unit 120 sends a message to the buffer manager 140 to exclusive-OR the mask value 00010000 with the erroneous byte 00010000. The result after the exclusive-OR operation would be 00000000, which is the same as the original data byte. The buffer manager 140 replaces the erroneous byte with this value.

At the same time that the sector 100 is read into the ECC unit 120, the data 102 and CRC 104 bytes are read into the CRC unit 118. There is a byte counter 156 within the CRC unit 118 which informs the CRC residue generator 128 when the last CRC byte is read into the CRC unit 118. After the data 102 and CRC 104 bytes are read into the CRC unit, the CRC residue generator 128 uses the data 102 and CRC 104 bytes to generate a CRC residue (or syndrome) using conventional methods. The generated CRC residue is the same byte length as the original CRC portion 104 stored in the sector 100. For example, if the CRC portion 104 is two bytes long, the CRC residue is also two bytes long. Using standard techniques, the CRC unit 118 uses the residue to detect errors in the data portion 102.

In a preferred embodiment, the second CRC check unit 124 performs another CRC check on the data bytes 102 while the data bytes 102 are sent to the host 112. This second CRC check unit 124 checks to see if the buffer unit 122 is functioning properly. If the buffer unit 122 is malfunctioning or damaged, the second CRC check unit will detect errors caused by the buffer unit 122.

In general, the CRC unit 118 must approve the read data before the read data is sent to the host 112. If both the ECC unit 120 and CRC unit 118 do not detect any errors in the data 102, then the disk drive controller 126 transmits the sector 100 to the host computer 112. If the CRC unit 118 and the ECC unit 120 disagree on whether any errors are detected in the sector 100 or what the specific detected errors are, the disk drive controller 126 will discard the read sector 100. No erroneous data is sent to the host 112, and the host 112 does not try to process erroneous data. The disk drive controller 126 will attempt another read operation of the same data sector 100 from the disk 116. This eliminates the need for the host 112 to discard the erroneous data and request a retransmission.

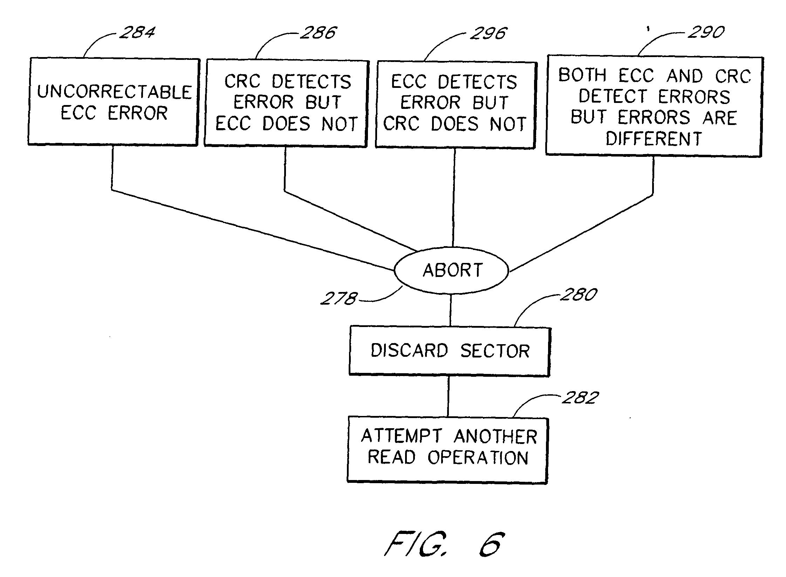

Figure 6 illustrates some of the events which cause the disk drive 110 to abort the current sector and attempt to read the same sector again from the disk platter 114. In one event 284, the ECC unit 120 detects an uncorrectable error in the data 102. An uncorrectable error flag 144 is then set in the disk drive controller 126 to cause an abort 278. The disk drive controller 126 discards the sector 100 in a function 280, and attempts another read operation of the same sector from the disk 116 in a function 282. An example of an uncorrectable error is where the ECC detects more than 20 byte errors in the sector. Because a 40-byte ECC generated from 4 interleaves can only correct up to 20 erroneous bytes, a sector with more than 20 bytes in error is uncorrectable.

If, as illustrated by an event 286, the CRC unit 118 detects at least one error in the data 102 but the ECC unit 120 does not, then the uncorrectable error flag 144 is set in the disk drive controller 126 to cause an abort 278. The disk drive controller 126 discards the sector 100 in the function 280 and attempts another read operation of the same sector from the disk 116 in the function 282.

If, as illustrated by an event 296, the ECC unit 120 detects and corrects at least one error in the data 102, and the CRC unit 118 does not detect an error, a miscorrection has occurred, and an abort 278 is initiated. The disk drive controller 126 discards the sector 100 in the function 280 and attempts another read operation of the same sector from the disk 116 in a function 282.

If, as illustrated by an event 290, both the CRC unit 118 and the ECC unit 120 detect at least one error, but the detected errors are not the same, then the uncorrectable error flag 144 is set in the disk drive controller 126 to cause an abort 278. The disk drive controller 126 discards the sector 100 in the function 280 and attempts another read operation of the same sector from the disk 116 in the function 282. For example, if the CRC unit 118 detects an error in the first data byte and the ECC unit 120 detects an error in the four-hundredth data byte, then the detected errors are not the same.

A preferred embodiment of the present invention is adapted to process all four situations. This preferred embodiment is ideally suited to process the two situations which are illustrated by the events 286, 290.

The use and operation of the CRC reconciliation module 130 in Figure 2 will now be described with reference to Figures 3, 4 and 5. Figure 3 is a block diagram of the CRC unit 118 and other components of the disk drive 110. The CRC reconciliation module 130 comprises a CRC shift register 150 with a feedback 294, a MUX 148, a compare circuit 276, four interleave error count pointers 154 (each 1 byte long), a byte counter 156, an interleave pointer 158 and a CRC error flag 160. As shown in Figure 3, the CRC reconciliation module 130 reads information from the CRC residue generator 128, the interleave error count registers 146 and the error location and value memory 136.

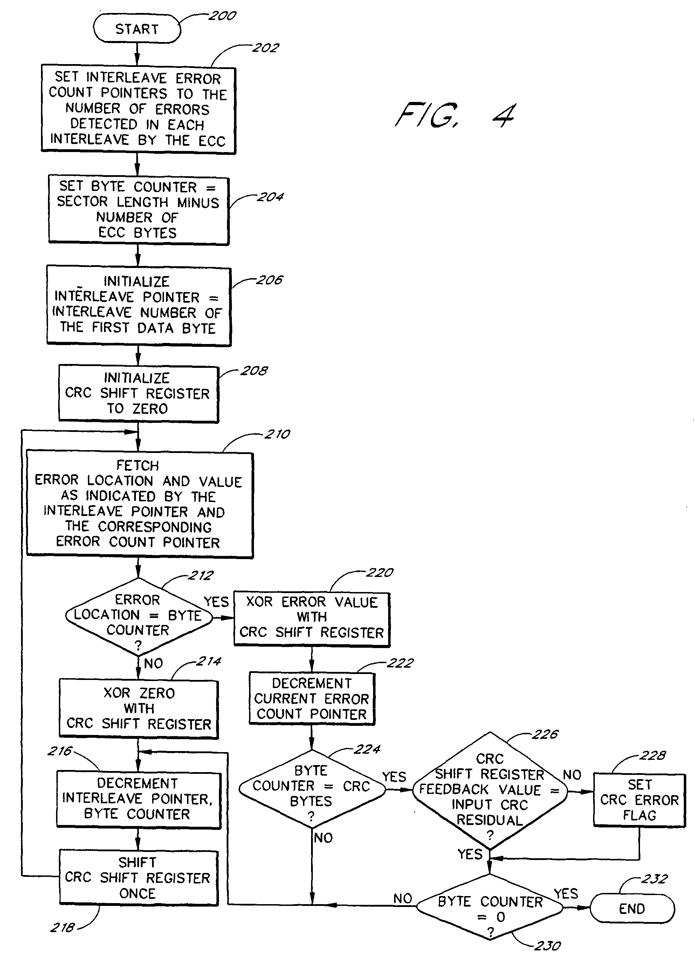

Figure 4 is a flow chart of the acts performed by the CRC reconciliation module 130. The CRC reconciliation module 130 may be implemented by a state machine to perform the acts in the flow chart of Figure 4. In general, the CRC reconciliation module 130 checks to see if the error location and mask values found by the ECC unit 120 are correct. The CRC reconciliation module 130 reads the error location and value memory 136 and compares these error entries with the CRC residue generated by the CRC residue generator 128. The CRC reconciliation module 130 detects any miscorrections made by the ECC unit 120. This significantly reduces the probability of miscorrections as seen by the host computer 112.

Specifically, at the end of the error correction process performed by the ECC unit 120, the ECC unit 120 sends a message to the CRC unit 118 that the ECC unit 120 is done. The CRC reconciliation module 130 begins its reconciliation process. This is represented by the 'start' oval 200 in Figure 4. In a block 202, the CRC reconciliation module 130 reads the interleave error count registers 146 to determine the number of errors found by the ECC unit 120. The interleave error count registers 146 inform the CRC reconciliation module 130 of how many error entries need to be read from the error location and value memory 136. The CRC reconciliation module 130 stores this information in its four interleave error count pointers 154. Unlike the interleave error count registers, which are static, the interleave error count pointers 154 are dynamic and can be decremented by the CRC reconciliation module 130.

Next, the CRC reconciliation module 130 sets the byte counter 156 equal to the sector length minus the number of ECC bytes 106. This is shown in a block 204. Thus, the disk drive 110 is configurable to process sectors of various lengths. The byte counter 156 keeps track of which byte in the sector 100 that the CRC reconciliation module 130 is currently processing. In a preferred embodiment, the entire sector length is between 542 to 560 bytes. The CRC reconciliation module 130 only takes into consideration the data bytes 102 and the CRC bytes 104. For example, if the combined data bytes 102 and the CRC bytes 104 are 520 bytes long, then the byte counter 156 is set to '520.' This value '520' is used in the examples below.

In a block 206, the CRC reconciliation module 130 initializes the interleave pointer 158 to the interleave number of the first data byte. The first data byte may be in any one of the four interleaves, depending on which order in which the disk controller 126 organized the interleaves. For example, if the first data byte is in the first interleave, then the interleave pointer 158 is first set to '1.' If the first data byte is in the third interleave, then the interleave pointer 158 is first set to '3.'

In a block 208, the CRC shift register 150 is initialized to zero. The structure of the CRC shift register 150 is substantially similar to a conventional CRC shift register as used in the CRC residue generator 128. A conventional CRC shift register is used to generate a CRC residue and to detect errors in a sector. The CRC shift register 150 in the CRC reconciliation module 130 is used to check the error mask values found by the ECC unit 120. The CRC shift register 150 is the same length as the original CRC portion 104, which is two to four bytes long. The structure of the feedback 294 is defined by a standard CRC generator polynomial.

In a block 210, the CRC reconciliation module 130 fetches a particular error location and value, as indicated by the interleave pointer 158 and the interleave error count pointer 154, from the error location and value memory 136. The interleave pointer 158 in Figure 3 indicates which column in Figure 5 is being accessed by the CRC reconciliation module 130. The interleave error count pointer 154 indicates which row is being accessed. For example, if the first data byte is associated with the first interleave and there are four error entries in the first interleave error entry block 250, the interleave pointer 158 equals '1' and the interleave error count pointer 154 equals '4.' If there are 520 bytes of data and CRC, and the four interleaves are organized from right to left as described above, the first data byte at the left end will be in the fourth interleave. But for the purposes of this example and the description below, the first data byte will be considered associated with the first interleave. The CRC reconciliation module 136 fetches the fourth error entry 258 in the first column 250 in Figure 5. As described above, the earliest error entries (closest to the left of the sector 100) are closest to the bottom of each column because of the 'push down' memory principle.

Once the CRC reconciliation module 130 has fetched an error entry from the error location and value memory 136, the module 130 first checks the error location part of the error entry (each error entry in the memory 136 has an error location and an error value). In a block 212, the CRC reconciliation module 130 checks to see if the error location of the particular error entry, as indicated by the interleave pointer 158 and the interleave error count pointer 154, is equal to the current location value stored in the byte counter 156. In the example above, the byte counter 156 is set for the CRC reconciliation module 130 to look at the first data byte, which is '520.' The first data byte is in the first interleave, and the interleave pointer 158 is set to '1.' The interleave error count pointer 154 for the first interleave indicates there are four error entries. The CRC reconciliation module 136 fetches the fourth error entry 258 in the first interleave error entry block 250 in Figure 5. The CRC reconciliation module 130 checks the error location 272 of this error entry 258. If this error location 272 does not match the current value in the byte counter 156, then the CRC reconciliation module knows the ECC unit 120 did not find an error in the first data byte. Thus, the CRC reconciliation module 130 moves on to a block 214.

In the block 214, the CRC reconciliation module 130 enters a '0' in the MUX 148 (Figure 3). The CRC reconciliation module 130 passes a '0' through an exclusive-OR (XOR) gate 152 which also receives the output of the CRC shift register 150. The output 294 of the exclusive-OR gate 152 feeds back into the CRC shift register 150 via the feedback 294. In a block 216, the CRC reconciliation module 130 decrements the interleave pointer 158 and the byte counter 156 by one. The byte counter 156 is decremented by '1' to '519' because the CRC reconciliation module 130 will check the second data byte from the left in the sector 100. After decrementing, the interleave pointer 158 is now equal to '4' because the bytes in the sector 100 are counted off from right to left as they are put into the four interleaves. The next time the interleave pointer 158 is decremented, it changes from '4' to '3' to '2' to '1' back to '4' to '3' and repeats. This decrementing repeats until the byte counter equals '0' in block 230.

Unlike the buffer interface 138 in the ECC unit 120, the CRC residue generator 128 and the CRC reconciliation module 130 do not process errors one interleave at a time because the CRC bytes 104 and the CRC residue is not generated from interleaves. The CRC residue is generated from the whole data portion 102. The CRC residue generator 128 and the CRC reconciliation module 130 process errors serially from left to right, starting with the first data byte from the left.

In a block 218, the CRC reconciliation module 130 cyclicly shifts the CRC shift register 150 once in accordance with standard CRC techniques. After the CRC reconciliation module 130 finishes comparing any errors found by the ECC unit 120 and the CRC unit 118 in the first data byte, the module 130 moves onto the second data byte in the data portion 102. To examine the second data byte in the data portion 102, the CRC reconciliation module 130 must look for errors found by the ECC unit 120 in the next interleave. Thus, the CRC reconciliation module 130 steps through each interleave error entry block 250, 252, 254, 256 in the error location and value memory 136.

The CRC reconciliation module 130 returns to the block 210, where the CRC reconciliation module 130 fetches the next error location and value. Specifically, following the example above, the interleave pointer 158 is now equal to '4.' The interleave error count pointer 154 for the fourth interleave is now equal to '2' because there are two error entries 270, 264 in the fourth interleave error entry block 256 of the sample error location and value memory chart in Figure 5. The CRC reconciliation module 130 fetches the second error entry 264 in the fourth interleave error entry block 256 shown in Figure 5. In the block 212, the CRC reconciliation module 130 compares the current value in the byte counter 156, which is '519,' with the error location part (first byte) of the error entry 264. If the current value in the byte counter 156 is equal to the error location part of the error entry 264, i.e., both are equal to '519,' this means that the ECC unit 120 found an error in this second data byte. The CRC reconciliation module 130 proceeds to a block 220, where the CRC reconciliation module 130 passes the error mask value (second byte) of the error entry 264 (Figure 5) through the MUX 148 and the exclusive-OR gate 152 with the output of the CRC shift register 150. As discussed above, this output is fed back into the CRC shift register 150 via the feedback 294 using conventional CRC techniques.

The feedback of the error mask value and the output of the CRC shift register 150 back into the CRC shift register 150 generates a 'CRC residue' in the CRC shift register 150. This CRC residue, generated and stored in the CRC shift register 150 in the CRC reconciliation module 130, now accounts for an error found in the second data byte by the ECC unit 120. As the CRC reconciliation module 130 proceeds through the data bytes, the CRC reconciliation module 130 will continue to pass error mask values from the ECC unit's error location and value memory 136 through the exclusive-OR gate 152 with the output of the CRC shift register 150. The output from the exclusive-OR gate 152 will continue to be fed back into the CRC shift register 150. Thus, the CRC residue generated by the CRC shift register 150 will eventually account for all the data byte errors found by the ECC unit 120. This process will continue until the byte counter 156 reaches the end of the data byte portion 102 and the beginning of the CRC portion 104.

Unlike the CRC residue generated by the CRC residue generator 128, the CRC residue in the CRC shift register 150 is not generated from the data bytes 102 using a conventional cyclic redundancy check generator polynomial. The CRC residue in the CRC shift register 150 is generated from the error mask values found by the ECC unit 120 using an ECC residue. The CRC residue in the CRC shift register 150 is generated without the original data bytes 102. This allows a later comparison between the CRC residue generated by the CRC residue generator 128 and the 'CRC residue' generated by CRC reconciliation module 130 from the error mask values found by the ECC unit 120.

In a block 222, the current value of the interleave error count pointer 154 for the fourth interleave is decremented by one and changes from '2' to '1.' This means there is only one more error entry 270 in the fourth interleave error entry block 256 left to be processed by the CRC reconciliation module 130. The CRC reconciliation module 130 decrements the current interleave error count pointer 154 each time the CRC reconciliation module 130 reaches the block 212 and proceeds to the blocks 220 and 222 because the location of an error entry matches the present value stored in the byte counter 156. The interleave error count pointer 154 is decremented each time the CRC reconciliation module 130 reaches the block 222 until one of two things occurs. In one situation, there are no more error entries in the interleave error entry blocks 250, 252, 254, 256 of the error location and value memory 136 for the CRC reconciliation module 130 to process, i.e., when the interleave error count pointer 154 for that particular interleave reaches '0.' In another situation, the byte counter 156 reaches the end of the CRC bytes, i.e., when the byte counter 156 equals '0.' In this latter situation, there may be more error entries in the error location and value memory 136, but these error entries relate to errors found in the ECC bytes 106. The CRC reconciliation module 130 does not check for miscorrections in the ECC bytes 106.

In a block 224, the CRC reconciliation module 130 compares the current value in the byte counter 156, which is '519,' with the location of the first CRC byte. The location of the first CRC byte in the example above is '4' because out of 520 combined data and CRC bytes, the first four bytes are CRC bytes and the next 516 are data bytes when counting from right to left. Because the byte counter 156 equals '519' and this is not equal to '4,' the CRC reconciliation module 130 proceeds to decrement the interleave pointer 158 to '3' and decrements the byte counter 156 to '518' in block 216. The CRC shift register 150 cyclicly shifts once for the next byte in block 218.

In the block 210, the interleave error count pointer 154 for the third interleave is '1' because there is only one error entry in the sample error location and value memory chart in Figure 5. The CRC reconciliation module 130 fetches the error location and value from the first (and only) error entry 262 in the third interleave error entry block 254. In the block 212, the CRC reconciliation module 130 compares the current value of the byte counter 156 with the error location (first 8 bits) of the error entry 262. If the value in the byte counter 156 matches the error location of the error entry 262, then the ECC unit 120 detected an error in the third data byte. If the byte counter 156 does not match the error location of the error entry 262, then the ECC unit 120 did not detect an error in the third data byte.

This process described by blocks 210 through 224 repeats itself until the byte counter 156 in the CRC reconciliation module 130 reaches the first CRC byte. In other words, the byte counter 156 equals '4.' At this point, the feedback value of the CRC shift register 150 accounts for all the mask values of the data byte errors found by the ECC unit 120. In a block 226, the CRC reconciliation module 130 uses the compare circuit 276 of Figure 3 to compare the feedback value of the CRC shift register 150 with a CRC residue input from the CRC residue generator 128. The CRC residue input from the CRC residue generator 128 accounts for all the data byte errors found by the CRC residue generator 128 using standard CRC methods. In a block 226, the CRC reconciliation module 130 compares any errors in the data bytes found by the CRC residue generator 128 with any errors found by the ECC unit 120.

If the two CRC residues are equal, then, in a block 230, the CRC reconciliation module 130 checks to see if the byte counter 156 is equal to '0.' The byte counter 156 is equal to '0' when the byte counter 156 has reached the end of the data and CRC bytes of the sector 100. If the byte counter 156 is not equal to '0,' then the CRC reconciliation module 130 continues to process the CRC bytes, as described in blocks 210 through 226.

If the two CRC residues being compared are not equal, as in a block 226, then the CRC reconciliation module 130 sets a CRC error flag 160 in block 228. This CRC error flag 160 immediately alerts (or interrupts) the disk drive controller 126 that the errors found by the CRC unit 118 are inconsistent with the errors found by the ECC unit 120. In a preferred embodiment, this CRC error flag 160 is located within the CRC reconciliation module 130 and is read by the disk drive controller 126. In another embodiment, the CRC error flag 160 is located within the disk drive controller 126.

When the CRC error flag 160 is set, the disk drive controller 126 aborts the read operation, discards the current sector 100, and attempts another read operation of the same sector 100 from the disk 116.

In a preferred embodiment, there are four CRC bytes. With four bytes of CRC, the CRC residue generator 128 generates four residues of one byte in length. Thus, there are four residues, one residue for each of the four bytes of CRC. The compare circuit 276 compares the four CRC residues generated by the CRC residue generator 128 with the four residues generated by the CRC shift register 150, one at a time. This process is shown in blocks 224, 226 and 230. There may be detected errors in the CRC bytes themselves.

In the block 230, the CRC reconciliation module 130 checks to see if the byte counter 156 is equal to '0.' If the byte counter 156 is not equal to '0,' then the CRC reconciliation module continues to process the CRC bytes, as described in blocks 210 through 226. If the byte counter 156 is equal to '0,' then the CRC reconciliation process ends in block 232.

During the time when the CRC reconciliation module 130 is comparing detected errors, the disk drive controller 126 may be sending one or more signals to the host computer 112 saying that the disk drive 110 is not ready to transmit data yet. Alternatively, the host computer 112 could be polling the disk drive 110 for a ready-to-transmit-data signal.

When the error correction and checking process described above repeats itself, another sector is read into the ECC unit 120. The ECC residue generator 132 generates a ECC residue for this sector, and the error location and value processor 134 writes the error locations and values, if any, onto the error location and error memory 136. The contents of the memory 136 are overwritten each time a new sector is processed by the ECC unit 120.

The present invention reduces the amount of erroneous data sent to the host computer 112. The host computer 112 does not have to discard erroneous data bytes, send a request to the disk drive to reread the data bytes from the disk platter and retransmit the data bytes, and wait for new data to be read and transferred. The host computer 112 saves time and can perform other tasks during this saved time.

The present invention also reduces the bandwidth taken up by the transmissions, retransmissions and CRC check messages on the SCSI bus. Furthermore, the present invention prevents breakdowns in software applications currently being run by host computers that cannot process the incorrect data.

While embodiments and applications of this invention have been shown and described, it will be apparent to those skilled in the art that various modifications are possible without departing from the scope of the invention. It is, therefore, to be understood that within the scope of the appended claims, this invention may be practiced otherwise than as specifically described.

## Claims

1. A system for determining whether an error correction code (ECC) unit has corrected errors in a sector of bytes read from a disk in a disk drive, the system comprising:
at least one disk from which the sector of bytes is read by the disk drive;
an ECC unit for receiving the sector of bytes which detects and corrects perceived errors in the sector of bytes and which generates data representing error locations and error values of the corrected perceived errors in the sector of bytes;
a Cyclic Redundancy Check (CRC) unit for receiving the sector of bytes, the CRC unit including a first CRC residue generator for generating a first CRC residue having a value responsive to errors in the sector of bytes, said CRC unit receiving the sector of bytes in parallel with the ECC unit receiving the sector of bytes;
a CRC reconciliation module which determines whether the ECC unit has correctly detected and corrected perceived errors in the sector of bytes, the CRC reconciliation module comprising:
a second CRC residue generator which receives the data from the ECC unit representing the error locations and error values of the corrected perceived errors in the sector of bytes, the second CRC residue generator generating a second CRC residue having a value responsive to the corrected perceived errors; and
a comparator that compares the first CRC residue with the second CRC residue and that generates an error indicator if the first CRC residue and the second CRC residue are different,
a buffer unit which temporarily stores at least a portion of the sector of bytes read from the disk, the said buffer unit implementing the corrections by the ECC unit to the sector of bytes; and
a disk drive controller which controls the transmission of the sector of bytes from the buffer unit to the host computer, said disk drive controller aborting the current sector of bytes within the buffer unit and attempting another read operation if the error indicator generated by the comparator indicates that the first CRC residue and the second CRC residue are different.

2. The system of Claim 1, wherein the sector of bytes comprises:
data bytes;
CRC bytes; and
ECC bytes.

3. The system of Claim 1, further comprising a second CRC check unit which performs another CRC check on the data bytes in the sector while the data bytes are sent to the host, said second CRC check unit checking to see if the buffer unit is functioning properly.

4. The system of Claim 1, wherein the sector of bytes is organised into a plurality of interleaves for generating a plurality of ECC residues, each of said ECC residues corresponding to only one interleave.

5. The system of Claim 4, wherein the sector of bytes is organised into four interleaves with each interleave used to generate its own ECC residue.

6. The system of Claim 4, wherein the ECC unit comprises:
an ECC residue generator for generating a residue for each interleave of bytes;
an error location and value processor for deriving the location and mask value of each detected error from the ECC residue generated by the ECC residue generator;
an error location and mask value memory for storing the location and mask value of each detected error in each interleave derived by the error location and value processor;
a plurality of interleave error count registers for keeping track of the number of errors detected by the ECC unit in each interleave; and
a buffer interface for correcting the detected erroneous bytes in the buffer unit using the error entries in the error location and value memory.

7. The system of Claim 6, wherein the error location and mask value memory comprises two-byte error entries, a first byte of each error entry representing the error location, and a second byte of each entry representing the error mask value.

8. The system of Claim 6, wherein the buffer interface corrects an erroneous byte in the sector by passing the erroneous byte and its error mask value through an exclusive - OR gate and replacing the erroneous byte with the output from the exclusive - OR gate.

9. The system of Claim 6, wherein the error location and mask value memory is a dual-port memory capable of being read by two different units at a time.

10. The system of Claim 1, wherein the second CRC residue generator comprises:
a CRC shift register which generates a CRC residue which accounts for all the error values found by the ECC unit;
a multiplexer which selects between an error mask value from the ECC unit and a '0' value;
at least one exclusive - OR gate which feeds an input of the CRC shift register with the output of the CRC shift register exclusive - ORed with a retrieved error mask value from the ECC unit; the comparator comparing
the CRC residue generated by the CRC residue generator and the CRC residue generated by the CRC shift register within the CRC reconciliation module; the CRC reconciliation module including
a plurality of interleave error count pointers which keep track of a number of error entries remaining for the CRC reconciliation module to process in each interleave;
a byte counter which keeps track of which byte the CRC reconciliation module is currently processing;
an interleave pointer which keeps track of which interleave error block the CRC reconciliation module is currently accessing from the ECC unit; arid
a CRC error flag which indicates that the CRC residue generated by the CRC residue generator and the CRC residue generated by the CRC shift register within the reconciliation module differ.

11. The system of Claim 10, wherein the CRC reconciliation module is adapted to process sectors of various lengths with variable data, CRC and ECC byte lengths.

12. A method of checking one or more corrections made by an error correction code (ECC) unit to a sector of bytes read from a disk in a disk drive comprising:
reading the sector of bytes into the ECC units and into a cyclic redundancy check (CRC) unit;
generating a first CRC error value residue from the sector of bytes from the disk drive, the first CRC error value residue having a value responsive to errors in the sector of bytes;
detecting and correcting perceived errors in the sector of bytes in the ECC unit and generating error data from the ECC unit which represents locations and values of the corrected perceived errors;
generating a second CRC residue using the error data from the ECC unit; and
comparing the first CRC residue with the second CRC residue; and
discarding the current sector read by the disk drive, without sending it to a host computer, and attempting another read operation of the same sector if the first CRC residue and the second CRC residue are different..

13. The method of Claim 12, further comprising:
simultaneously reading the sector of bytes into the CRC unit and the ECC.

14. The method of Claim 12, further comprising:
discarding the current sector read by the disk drive, without sending it to a host computer, and attempting another read operation of the same sector if the errors detected by the ECC unit are uncorrectable.

15. The system of Claim 1, wherein said CRC unit receives the sector of bytes from the disk at approximately the same time the ECC unit receives the sector of bytes.

## Patentansprüche

1. System zum Bestimmen, ob eine Fehlerkorrektureinheit (ECC-Einheit) in einen Bytesektor, der von einer Platte in einem Plattenlaufwerk gelesen wurde, Fehler korrigiert hat, wobei das System aufweist:
zumindest eine Platte bzw. Festplatte, von welcher der Bytesektor durch das Plattenlaufwerk gelesen wird,
eine ECC-Einheit für den Empfang des Bytesektors, welche in dem Bytesektor wahrgenommene Fehler erfaßt und korrigiert und welche Daten erzeugt, die Fehlerpositionen und Fehlerwerte der korrigierten, wahrgenommenen Fehler in dem Bytesektor wiedergeben,
eine Einheit zur zyklischen Redundanzüberprüfung (CRC) für die Aufnahme des Bytesektors, wobei die CRC-Einheit einen ersten CRC-Restgenerator zum Erzeugen eines ersten CRC-Restwertes aufweist, der einen Wert hat, welcher auf Fehler in dem Bytesektor anspricht, wobei die CRC-Einheit den Bytesektor parallel zum Empfang des Bytesektors durch die ECC-Einheit empfängt,
ein CRC-Abgleichmodul, welches feststellt, ob die ECC-Einheit wahrgenommene Fehler in dem Bytesektor korrekt erfaßt und korrigiert hat, wobei das CRC-Abgleichsmodul aufweist:
einen zweiten CRC-Restgenerator, welcher die Daten von der ECC-Einheit empfängt, welche die Fehlerpositionen und Fehlerwerte der korrigierten, wahrgenommenen Fehler in dem Bytesektor wiedergibt, wobei der zweite CRC-Restwertgenerator einen zweiten CRC-Restwert erzeugt, der einen Wert hat, welcher den korrigierten, wahrgenommenen Fehlern entspricht, und
einen Vergleicher, welcher den ersten CRC-Restwert mit dem zweiten CRC-Restwert vergleicht und eine Fehleranzeige erzeugt, falls der erste CRC-Restwert und der zweite CRC-Restwert voneinander verschieden sind,
eine Puffereinheit, welche zeitweise zumindest einen Teil des von der Festplatte gelesenen Bytesektors speichert, wobei die Speichereinheit die Korrekturen durch die ECC-Einheit in dem Bytesektor implementiert, und
eine Plattenlaufwerlcssteuerung, welche die Übertragung des Bytesektors von der Puffereinheit an den Hostcomputer steuert, wobei die Plattenlaufwerkssteuerung den aktuellen Bytesektor innerhalb der Puffereinheit verwirft und einen weiteren Lesevorgang versucht, falls die durch den Vergleicher erzeuge Fehleranzeige anzeigt, daß der erste CRC-Restwert und der zweite CRC-Restwert verschieden sind.

2. System nach Anspruch 1, wobei der Bytesektor aufweist:
Datenbytes,
CRC-Bytes, und
ECC-Bytes.

3. System nach Anspruch 1, welches weiterhin eine zweite CRC-Prüfeinheit aufweist, die eine weitere CRC-Prüfung mit den Datenbytes in dem Sektor vornimmt, während die Datenbytes an den Host gesendet werden, wobei die zweite CRC-Prüfeinheit eine Überprüfung vornimmt, um festzustellen, ob die Puffereinheit ordnungsgemäß funktioniert.

4. System nach Anspruch 1, wobei der Bytesektor in einer Mehrzahl von Verschachtelungen organisiert ist, um eine Mehrzahl von ECC-Restwerten zu erzeugen, wobei jeder der ECC-Restwerte nur jeweils einer Verschachtelung bzw. Überlappung entspricht.

5. System nach Anspruch 4, wobei der Bytesektor in vier Verschachtelungen organisiert ist, wobei jede Verschachtelung verwendet wird, um ihren eigenen ECC-Restwert zu erzeugen.

6. System nach Anspruch 4, wobei die ECC-Einheit aufweist:
einen ECC-Restwertgenerator, um für jede Verschachtelung von Bytes einen Restwert zu erzeugen,
einen Fehlerpositions- und Werteprozessor, um die Position und den Maskenwert für jeden erfaßten Fehler aus dem durch den ECC-Restwertgenerator erzeugten Restwert abzuleiten,
einen Speicher für die Fehlerposition und den Maskenwert, um die Position und den Maskenwert für jeden erfaßten Fehler in jeder Verschachtelung zu speichern, welcher durch den Fehlerpositions- und Werteprozessor abgeleitet wurde,
eine Mehrzahl von Verschachtelungsfehlerzählregistern, um die Anzahl der Fehler, die durch die ECC-Einheit in jeder Verschachtelung erfaßt wurden, zu verfolgen und
eine Pufferschnittstelle, um die erfaßten fehlerhaften Bytes in der Puffereinrichtung unter Verwendung der Fehlereinträge in dem Fehlerpositions- und Wertespeicher zu korrigieren.

7. System nach Anspruch 6, wobei der Fehlerpositions- und Maskenwertspeicher Einträge von zwei Bytes aufweist, wobei ein erstes Byte jedes Fehlereintrags die Fehlerposition und ein zweites Byte jedes Fehlereintrags den Fehlermaskenwert wiedergibt.

8. System nach Anspruch 6, wobei die Pufferschnittstelle ein fehlerhaftes Byte in dem Sektor korrigiert, indem sie das fehlerhafte Byte und seinen Fehlermaskenwert durch ein Ausschließlich-ODER-Gatter leitet und das fehlerhafte Byte durch den Ausgangswert des Ausschließlich-ODER-Gatters ersetzt.

9. System nach Anspruch 6, wobei der Fehlerpositions- und Maskenwertspeicher ein Speicher mit zwei Anschlüssen ist (dual port), der in der Lage ist, gleichzeitig von zwei verschiedenen Einheiten gelesen zu werden.

10. System nach Anspruch 1, wobei der zweite CRC-Restwertgenerator aufweist:
ein CRC-Schieberegister, welches einen CRC-Restwert erzeugt, der alle Fehlerwerte, die durch die ECC-Einheit gefunden wurden, berücksichtigt,
einen Multiplexer, welcher zwischen einem Fehlermaskenwert von der ECC-Einheit und einem Null-Wert auswählt,
zumindest ein Ausschließlich-ODER-Gatter, welches einen Eingang des CRC-Schieberegisters mit dem über Ausschließlich-ODER mit dem gewonnenen Fehlermaskenwert von der ECC-Einheit verknüpften CRC-Schieberegisterwert versorgt, wobei der Komparator vergleicht:
den durch den CRC-Restwertgenerator erzeugten CRC-Restwert und den CRC-Restwert, der durch das CRC-Schiebeabgleichmodul erzeugt wurde, wobei das CRC-Abgleichmodul aufweist:
eine Mehrzahl von Zeigern auf Verschachtelungsfehlerzahlen, welche eine Anzahl von Fehlereinträgen verfolgen, die für die Verarbeitung durch das CRC-Abgleichmodul in jeder Verschachtelung verbleiben,
einen Bytezähler, welcher verfolgt, welches Byte das CRC-Abgleichmodul gerade verarbeitet,
einen Verschachtelungszeiger, welcher verfolgt, auf welchen Verschachtelungsfehlerblock das CRC-Abgleichmodul gerade von der ECC-Einheit zugreift, und
ein CRC-Fehlerflag, welches anzeigt, daß der CRC-Restwert, der durch den CRC-Restwertgenerator erzeugt wurde, und der CRC-Restwert, der durch das CRC-Schieberegister erzeugt wurde, sich innerhalb des Abgleichmoduls unterscheiden.

11. System nach Anspruch 10, wobei das CRC-Abgleichmodul dafür ausgelegt ist, Sektoren unterschiedlicher Länge mit variablen Daten, CRC- und ECC-Bytelängen zu verarbeiten.

12. Verfahren zum Überprüfen einer oder mehrerer Korrekturen, welche durch eine Fehlerkorrektureinheit an einem Bytesektor vorgenommen wurden, der von einer Platte in einem Plattenlaufwerk gelesen wurde, mit:
Lesen des Bytesektors in die ECC-Einheiten und in eine Einheit zur zyklischen Redundanzüberprüfung (CRC-Einheit),
Erzeugen eines ersten CRC-Fehlerrestwerts aus dem Bytesektor von dem Plattenlaufwerk, wobei der erste CRC-Fehlerrestwert einen Wert hat, welcher von den Fehlern in dem Bytesektor abhängt,
Erfassen und Korrigieren wahrgenommener Fehler in dem Bytesektor in der ECC-Einheit und Erzeugen von Fehlerdaten aus der ECC-Einheit, welche Positionen und Werte der korrigierten, wahrgenommenen Fehler wiedergeben,
Erzeugen eines zweiten CRC-Restwerts unter Verwendung der Fehlerdaten aus der ECC-Einheit und
Vergleichen des ersten CRC-Restwerts mit dem zweiten CRC-Restwert, und
Verwerfen des aktuellen Sektors, der von dem Festplattenlaufwerk gelesen wurde, ohne ihn an einen Hostcomputer zu senden, und Versuchen eines weiteren Lesevorgangs desselben Sektors, falls der erste CRC-Restwert und der zweite CRC-Restwert verschieden sind.

13. Verfahren nach Anspruch 12, welches weiterhin aufweist:
gleichzeitiges Lesen des Bytesektors in die CRC-Einheit und die ECC.

14. Verfahren nach Anspruch 12, welches weiterhin aufweist:
Verwerfen des von dem Plattenlaufwerk aktuell gelesenen Sektors, ohne ihn an einen Hostcomputer zu senden, und Versuchen eines weiteren Lesevorgangs desselben Sektors, wenn die durch die ECC-Einheit erfaßten Fehler nicht korrigierbar sind.

15. System nach Anspruch 1, wobei die CRC-Einheit den Bytesektor von der Festplatte näherungsweise zur gleichen Zeit empfängt wie die ECC-Einheit diesen Sektor empfängt.

## Revendications

1. Système destiné à déterminer si une unité de code de correction d'erreur (ECC pour Error Correction Code) a corrigé des erreurs dans un secteur d'octets lu à partir d'un disque dans un régisseur à disque, le système comprenant :
au moins un disque à partir duquel le secteur d'octets est lu par le régisseur à disque ;
une unité ECC, destinée à recevoir le secteur d'octets, unité ECC qui détecte des erreurs et corrige les erreurs détectées dans le secteur d'octets et qui génère des données représentant les emplacements d'erreur et les valeurs d'erreur des erreurs détectées corrigées dans le secteur d'octets ;
une unité de Vérification de Redondance Cyclique (CRC pour Cyclic Redundancy Check) destinée à recevoir le secteur d'octets, l'unité CRC comprenant un premier générateur de résidu CRC destiné à générer un premier résidu CRC possédant une valeur dépendant des erreurs situées dans le secteur d'octets, ladite unité CRC recevant le secteur d'octets parallèlement à la réception du secteur d'octets par l'unité ECC ;
un module de rapprochement CRC qui détermine si l'unité ECC a correctement détecté et corrigé les erreurs détectées dans le secteur d'octets, le module de rapprochement CRC comprenant :
un second générateur de résidu CRC qui reçoit, en provenance de l'unité ECC, les données représentant les emplacements d'erreur et les valeurs d'erreur des erreurs détectées corrigées dans le secteur d'octets, le second générateur de résidu CRC générant un second résidu CRC possédant une valeur dépendant des erreurs détectées corrigées ; et
un comparateur qui compare le premier résidu CRC au second résidu CRC et qui génère un indicateur d'erreur si le premier résidu CRC et le second résidu CRC sont différents,
une unité de tampon qui stocke temporairement au moins une partie du secteur d'octets lu à partir du disque, ladite unité de tampon mettant en place les corrections par l'unité ECC sur le secteur d'octets ; et
un régisseur à disque qui commande la transmission du secteur d'octets de l'unité de tampon vers l'odinateur hôte, ledit régisseur à disque abandonnant le secteur d'octets courant dans l'unité de tampon et tentant une autre opération de lecture si l'indicateur d'erreur généré par le comparateur indique que le premier résidu CRC et le second résidu CRC sont différents.

2. Système selon la revendication 1, dans lequel le secteur d'octets comprend :
des octets de données ;
des octets de CRC ; et
des octets d'ECC.

3. Système selon la revendication 1, comprenant de plus une seconde unité de vérification de CRC qui réalise une autre vérification de CRC sur les octets de données dans le secteur tandis que les octets de données sont envoyés à l'hôte, ladite seconde unité de vérification de CRC effectuant une vérification pour voir si l'unité de tampon fonctionne correctement.

4. Système selon la revendication 1, dans lequel le secteur d'octets est organisé en une pluralité d'items intercalés pour générer une pluralité de résidus ECC, chacun desdits résidus ECC correspondant à un unique item intercalé.

5. Système selon la revendication 4, dans lequel le secteur d'octets est organisé en quatre items intercalés, chaque item intercalé étant utilisé pour générer son propre résidu ECC.

6. Système selon la revendication 4, dans lequel l'unité ECC comprend :
un générateur de résidu ECC pour générer un résidu pour chacun des items intercalés d'octets ;
un processeur d'emplacement et de valeur d'erreur destiné à calculer l'emplacement et la valeur de masque de chaque erreur détectée à partir du résidu ECC généré par le générateur de résidu ECC ;
une mémoire d'emplacement et de valeur de masque d'erreur destinée à stocker l'emplacement et la valeur de masque de chaque erreur détectée dans chacun des items intercalés calculés par le processeur d'emplacement et de valeur d'erreur ;
une pluralité de registres de comptage d'erreurs d'items intercalés destinés à garder une trace du nombre d'erreurs détectées par l'unité ECC dans chaque item intercalé ; et
une interface de tampon destinée à corriger les octets erronés détectés dans l'unité de tampon en utilisant les entrées d'erreur dans la mémoire d'emplacement et de valeur d'erreur.

7. Système selon la revendication 6, dans lequel la mémoire d'emplacement et de valeur de masque d'erreur comprend des entrées d'erreur à deux octets, le premier octet de chaque entrée d'erreur représentant l'emplacement de l'erreur et le second octet de chaque entrée représentant la valeur de masque de l'erreur.

8. système selon la revendication 6, dans lequel l'interface de tampon corrige un octet erroné dans le secteur en passant l'octet erroné et sa valeur de masque d'erreur à travers une porte OU-exclusif et en remplaçant l'octet erroné par la sortie de la porte OU-exclusif.

9. Système selon la revendication 6, dans lequel la mémoire d'emplacement et de valeur de masque d'erreur est une mémoire à deux ports capable d'être lue par deux unités différentes en même temps.

10. Système selon la revendication 1, dans lequel le second générateur de résidu CRC comprend :
un registre à décalage de CRC qui génère un résidu CRC qui rend compte de toutes les valeurs d'erreur trouvées par l'unité ECC ;
un multiplexeur qui choisit entre une valeur de masque d'erreur provenant de l'unité ECC et une valeur '0' ;
au moins une porte OU-exclusif qui alimente une entrée du registre à décalage de CRC avec la sortie du registre à décalage de CRC affecté d'un OU-exclusif avec une valeur de masque d'erreur récupérée à partir de l'unité ECC ; le comparateur comparant
le résidu CRC généré par le générateur de résidu CRC et le résidu CRC généré par le registre à décalage de CRC dans le module de rapprochement CRC ; le module de rapprochement CRC comprenant
une pluralité de pointeurs de comptage d'erreurs d'items intercalés qui gardent une trace d'un nombre d'entrées d'erreur restant à traiter pour le module de rapprochement CRC dans chaque item intercalé ;
un compteur d'octets qui garde une trace de l'octet qui est en cours de traitement par le module de rapprochement CRC ;
un pointeur d'item intercalé qui garde une trace du bloc d'erreur d'item intercalé auquel le module de rapprochement CRC est en train d'accéder à partir de l'unité ECC ; et
un sémaphore d'erreur CRC qui indique que le résidu CRC généré par le générateur de résidu CRC et le résidu CRC généré par le registre à décalage de CRC dans le module de rapprochement sont différents.

11. Système selon la revendication 10, dans lequel le module de rapprochement CRC est adapté pour traiter des secteurs de différentes longueurs possédant différentes longueurs d'octets de données, d'octets de CRC et d'octets d'ECC.

12. Procédé de vérification d'une ou plusieurs corrections réalisées par une unité de code de correction d'erreur (ECC) sur un secteur d'octets lu à partir d'un disque dans un régisseur à disque, comprenant :
la lecture du secteur d'octets dans l'unité ECC et dans une unité de vérification de redondance cyclique (CRC) ;
la génération d'un premier résidu de valeur d'erreur CRC à partir du secteur d'octets provenant du régisseur à disque, le premier résidu de valeur d'erreur CRC possédant une valeur dépendant des erreurs se trouvant dans le secteur d'octets ;
la détection et la correction des erreurs détectées dans le secteur d'octets dans l'unité ECC et la génération de données d'erreur, à partir de l'unité ECC, qui représentent les emplacements et les valeurs des erreurs détectées corrigées ;
la génération d'un second résidu CRC en utilisant les données d'erreur provenant de l'unité ECC ; et
la comparaison du premier résidu CRC et du second résidu CRC ; et
le rejet du secteur courant lu par le régisseur à disque, sans l'envoyer à un ordinateur hôte, et l'essai d'une autre opération de lecture du même secteur si le premier résidu CRC et le second résidu CRC sont différents.

13. Procédé selon la revendication 12, comprenant de plus :
la lecture simultanée du secteur d'octets dans l'unité CRC et l'ECC.

14. Procédé selon la revendication 12, comprenant de plus :
le rejet du secteur courant lu par le régisseur à disque, sans l'envoyer à un ordinateur hôte, et l'essai d'une autre opération de lecture du même secteur si les erreurs détectées par l'unité ECC sont irrécupérables.

15. Système selon la revendication 1, dans lequel ladite unité CRC reçoit le secteur d'octets en provenance du disque à peu près en même temps que l'unité ECC reçoit le secteur d'octets.
